# EUROPEAN PATENT APPLICATION

(11) **EP 2 161 354 A1**
(43) Date of publication of application: **10.03.2010**
(21) Application number: 08764617.0
(22) Date of filing: 23.05.2008
(51) Int. Cl.: C23F 11/00, B23K 1/20

(54) **COPPER SURFACE TREATING AGENT AND SURFACE TREATMENT METHOD**

(30) Priority: 14.06.2007 JP 2007157733
(71) Applicant: MEC COMPANY LTD., Amagasaki-shi Hyogo 660-0832 (JP)
(72) Inventor: YAGUMA, Noriko, Amagasaki-shi Hyogo 660-0832 (JP); FURUKAWA, Yoshiaki, Amagasaki-shi Hyogo 660-0832 (JP); TOJIMA, Hiroyoshi, Amagasaki-shi Hyogo 660-0832 (JP)
(74) Representative: Luderschmidt, Schüler & Partner
(86) International application number: PCT/JP2008/059571
(87) International publication number: WO 2008/152900

(57) **Abstract**

The present invention provides a copper surface treating agent and a surface treatment method which can satisfy both of heat resistance and solderability. The copper surface treating agent of the present invention is a copper surface treating agent, comprising an acid, benzimidazole compounds and water, which is **characterized in that** at least a first benzimidazole compound and a second benzimidazole compound having a lower melting point than that of the first benzimidazole compound by 70°C or more are contained as the benzimidazole compounds.

## Description

### TECHNICAL FIELD

The present invention relates to a copper surface treating agent and a surface treatment method using this agent.

### BACKGROUND ART

The copper surface treating agent is used to form a coating film on a copper surface on which wiring is to be formed, for example, in order to improve the rust prevention or solderability thereof. As the surface treating agent, known is an agent containing an imidazole compound which is to be a main component of a coating film to be formed. For example, Patent Document 1 discloses the use of a 2-position alkylbenzimidazole compound and an organic acid together. Patent Documents 2 to 4 each disclose a surface treating agent containing an imidazole compound. Patent Document 5 discloses a using method of a preflux containing an imidazole based compound. Patent Document 6 discloses a copper surface treating agent containing two imidazole compounds of 4,4-methylene-bis-(2-undecyl-5-methylimidazole) and 2-undecyl-4-methylimidazole. Patent Document 7 discloses a copper surface treating agent containing two benzimidazole compounds of a 2-alkyl-4-methylbenzimidazole compound, and a 2-alkyl-5-methylbenzimidazole compound.

A rust preventing coating film formed from such a copper surface treating agent is required to be stable even after the film is repeatedly subjected to reflow at high temperature, and is also required to keep solderability. However, it is difficult for conventional copper surface treating agents to satisfy both of heat resistance and solderability.

Patent Document 1: Japanese Patent Application Laid-Open (JP-A) No. 4-80375
Patent Document 2: JP-A No. 5-25407
Patent Document 3: JP-A No. 5-186888
Patent Document 4: JP-A No. 7-54169
Patent Document 5: JP-A No. 5-186880
Patent Document 6: JP-A No. 61-23775
Patent Document 7: JP-A No. 4-99285

### DISCLOSURE OF THE INVENTION

### PROBLEMS TO BE SOLVED BY THE INVENTION

The present invention provides a copper surface treating agent and a surface treatment method which can satisfy both of heat resistance and solderability in order to solve the above-mentioned conventional problems.

### MEANS FOR SOLVING THE PROBLEMS

The copper surface treating agent of the present invention is a copper surface treating agent, comprising an acid, benzimidazole compounds and water, which is **characterized in that** at least a first benzimidazole compound and a second benzimidazole compound having a lower melting point than that of the first benzimidazole compound by 70°C or more are contained as the benzimidazole compounds.

In the invention, "copper" may be pure copper or be made of copper alloy. In the present specification, the word "copper" refers to pure copper or copper alloy.

Also, the surface treatment method of the present invention is a surface treatment method for treating a copper surface, wherein the copper surface is treated with the above copper surface treating agent of the present invention.

### BEST MODE FOR CARRYING OUT THE INVENTION

In the invention, attention has been paid to the melting point of a benzimidazole compound in order for a treating agent to satisfy heat resistance and solderability. A benzimidazole compound having a high melting point (first benzimidazole compound) gives a coating film which does not soften easily at the temperature for soldering, so as to exhibit high heat resistance since the compound is high in melting point; however, the compound is poor in solderability. A benzimidazole compound having a low melting point (second benzimidazole compound) is good in solderability; however, the compound is low in heat resistance at high temperature when soldering is performed. In the invention, the first benzimidazole compound and the second benzimidazole compound are mixed with each other, whereby both of heat resistance and solderability can be satisfied. About the first benzimidazole compound, the melting point is preferably from 200 to 300°C, more preferably from 230 to 270°C. About the second benzimidazole compound, the melting point is preferably from 95 to 130°C, more preferably from 98 to 120°C.

### (Examples of the first benzimidazole compound)

Examples of the first benzimidazole compound include the following:
2-(1'-ethylpropyl)benzimidazole (EPrBI): melting point= 265°C,
2-(2'-carboxyphenyl)benzimidazole: melting point= 264°C,
2-(2'-hydroxyphenyl)benzimidazole: melting point= 242°C,
2-(1-naphthylmethyl)benzimidazole (NMBI): melting point= 241°C,
2-(2'-chlorophenyl)benzimidazole: melting point= 232°C,
2-(2'-methylphenyl) benzimidazole: melting point=218°C,
2-(1'-aminophenyl)benzimidazole: melting point= 214°C, and
2-(1'-ethylpentyl)benzimidazole (EPeBI): melting point= 207°C.
These may be used alone or in a mixture form.

### (Examples of the second benzimidazole compound)

Examples of the second benzimidazole compound include the following:
2-nonylbenzimidazole (NBI): melting point = 127°C,
2-(5'-tolyl)penthylenebenzimidazole (TPBI): melting point = 121°C,
1,4-bisbenzimidazolebutane (BBIB): melting point = 120°C,
2-decylbenzimidazole: melting point = 114°C,
2-(5'-xylyl)pentylenebenzimidazole (XPBI): melting point = 112°C,
2-undecylbenzimidazole (UBI): melting point = 109°C,
2-dodecylbenzimidazole: melting point = 109°C,
2-tridecylbenzimidazole: melting point = 105°C,
5-chloro-2-octylbenzimidazole (COBI): melting point = 100°C, and
2-tetradecylbenzimidazole: melting point = 99°C.
These may be used alone or in a mixture form.

The total concentration of the first and second benzimidazole compounds is preferably from 0.05 to 0.4% by weight, more preferably from 0.1 to 0.3% by weight. When the total concentration of the benzimidazole compounds is in the range, a coating film is easily formed and the solubility is also satisfied.

About a preferred ratio between the first and second benzimidazole compounds, the ratio by weight is preferably from 1/9 to 9/1, more preferably from 3/7 to 7/3. When the blend ratio between the individual benzimidazole compounds is in the range, advantages of the two-component system, that is, heat resistance and solderability can be satisfied.

It is sufficient that the copper surface treating agent of the invention contains one or more compounds as each of the first and second benzimidazole compounds. The agent may contain a benzimidazole compound other than the first and second benzimidazole compounds. For example, a third benzimidazole compound exhibiting a melting point between those of the first and second benzimidazole compounds may be contained. Any benzimidazole compound is better in heat resistance than other imidazole compounds; therefore, a coating film therefrom does not soften easily at high temperature also, which is the temperature when soldering is performed.

### (Examples of the acid)

The acid contained in the copper surface treating agent of the invention may be an organic acid or an inorganic acid, and is in particular preferably an organic acid since the acid is excellent in power of dissolving the benzimidazole compounds and can further give a rust preventing film good in adhesiveness. Examples of the organic acid include acetic acid, formic acid, propionic acid, glycolic acid, butyric acid, acrylic acid, crotonic acid, oxalic acid, malonic acid, succinic acid, adipic acid, maleic acid, acetylenedicarboxylic acid, monochloroacetic acid, trichloroacetic acid, monobromoacetic acid, tribromoacetic acid, lactic acid, oxybutyric acid, glyceric acid, tartaric acid, malic acid, citric acid, caproic acid, and enanthic acid. These organic acids may be used in combination of two or more thereof. In the case of using, for example, a mixture of acetic acid or formic acid with caproic acid, enanthic acid or some other acid, the mixture can dissolve the benzimidazole compounds in the state that the compounds are in particular stable. Caproic acid or enanthic acid acts as a solubilizing agent to make it possible that the benzimidazole compounds can stably be dissolved in a mixed solvent of the acid with acetic acid or formic acid and water.

In the copper surface treating agent of the invention, it is necessary that two or more benzimidazole compounds having melting points different from each other can be dissolved. Since these benzimidazole compounds are different from each other in solubility in an acid, it is particularly effective to use the listed-up acids in a mixture form.

Examples of the inorganic acid, which can be used in the copper surface treating agent of the invention, hydrochloric acid, sulfuric acid, nitric acid, and phosphoric acid.

These acids are each added to dissolve the benzimidazole compounds stably, and the content thereof is varied in accordance with the kinds and the amounts of the benzimidazole compounds used, and others; thus, the content can be specified without reservation. However, the content is set in such a range that the benzimidazole compounds can stably be dissolved in the copper surface treating agent, and is usually from 1 to 40% by weight.

More preferably, the copper surface treating agent of the invention further contains at least one azole selected from imidazoles other than any benzimidazole compound, triazoles, and tetrazoles. This is because the speed of forming a coating film becomes large so that the treating period can be made short.

Examples of the imidazoles include imidazole, 2-methylimidazole, 2-ethylimidazole, 2-propylimidazole, 2-butylimidazole, 2-hexylimidazole, 2-octylimidazole, 2-nonylimidazole, 2-decylimidazole, 2-undecylimidazole, 2-ethyl-4-methylimidazole, and 2-undecyl-4-methylimidazole. Examples of the triazoles include triazole, 3-amino-1,2,4-triazole, 3-amino-5-ethyltriazole, 4-amino-1,2,4-triazole, and 3,5-diamino-1,2,4-triazole. Examples of the tetrazoles include tetrazole, 5-aminotetrazole, 5-methyltetrazole, 5-ethyltetrazole, and 1-(β-aminoethyl)tetrazole. These azoles have a nature of being easily adsorbed onto a copper surface and have no group large in molecular weight so as to be good in solubility; thus, the azoles each permits a coating film to be formed on a copper surface in a short time. Of these azoles, azoles having a molecular weight of 250 or less are preferred from the viewpoint of solubility. From the viewpoint of solubility and coating-film-forming speed, more preferred are azoles having a molecular weight of 250 or less and further having at least one substituent selected from a methyl group, an ethyl group and linear alkyl groups having 3 or more carbon atoms.

When the copper surface treating agent of the invention contains the azole(s), the value obtained by dividing the concentration of the azole (s) by the total concentration of the first and second benzimidazole compounds is, for example, from 0.01 to 0.10, preferably from 0. 03 to 0.10, more preferably from 0.03 to 0.07. When the value is in this range, the coating-film-forming speed can be improved into such a degree that the effects of improving the heat resistance and the solderability are not hindered.

### (Other components)

One or more other components may be appropriately added, examples thereof including zinc or a zinc-containing compound as a heat resistance improver, a bromide or a bromine compound as a solderability improver, and copper or a copper compound as a promoter for forming a coating film on a copper surface. The content by percentage of the component (s) is, for example, from about 0.01 to 2.0% by weight.

The copper surface treating agent of the invention can easily be prepared by dissolving the benzimidazole compounds and so on into a mixed solvent of water and an acid. The water is preferably water obtained by removing ionic materials and impurities, and is, for example, ion-exchange water, pure water, or ultrapure water.

### [Examples]

The invention will be more specifically described by way of examples hereinafter.

### <Solderability>

### (Experiment 1)

Prepared were double-sided copper clad laminates (width: 7.8 cm, and length: 4.8 mm) in each of which a copper foil in thickness of 18 µm was caused to adhere onto each surface of a glass epoxy substrate (GEA-67N, manufactured by Hitachi Chemical Co., Ltd., thickness: 1.6 mm), and then 160 through holes diameter of 0.8 mm were made in each of the plates to produce members to be treated.

Subsequently, each of the members to be treated was immersed in a microetching agent (MECBRITE CB-801, manufactured by Mec Co., Ltd.) so as to etch the copper foil surfaces by 1 µm, and then the member was washed with water. Thereafter, the members were immersed into copper surface treating agents of Examples 1 to 26 and Comparative Examples 1 to 4 each having a composition shown in Table 1 described below, respectively, for 60 seconds. The members were then washed with water, and dried. The temperature of each of the copper surface treating agents was set to 30°C.

Next, each of the dried members to be treated was subjected to reflow treatment 2 times. For the reflow treatment, a convection hot air reflow furnace was used, and the member was heated at a temperature for setting the surface temperature of the member into the range of 240 to 245°C for 40 seconds per time of the reflow treatment.

Subsequently, the member to be treated was subjected to post-flux treatment with spraying. The post-flux agent used was an agent AGF-880 manufactured by Asahi Chemical Research Laboratory Co., Ltd. Thereafter, the member was subjected to flow treatment. In the flow treatment, the member was first heated at a temperature for setting the surface temperature of the member to 100°C for 80 seconds to conduct pre-heating. The member was then subjected to double wave treatment under conditions that the temperature of solder was set to 255°C. About the solder used at this time, the ratio by weight of Sn/Ag/Cu was 96.5/3/0.5.

The double wave treatment in the present experiment was a treatment wherein the member to be treated and the solder were brought into contact with each other for 2.5 seconds, and after an interval of 2.5 seconds the member to be treated and the solder were again brought into contact with each other for 3 seconds.

About each of the members to be treated, the soldering defective percentage was checked. The soldering defective percentage was the percentage of through holes wherein soldering defection was generated in the 160 through holes. In the experiment, the soldering defection refers to a case where it was recognized by the visual observation that the solder was not completely filled into an observed through hole.

### (Experiment 2)

Prepared were single-sided copper clad laminates in each of which a copper foil of 18 µm thickness was caused to adhere onto a surface of a glass epoxy substrate (GEA-67N, manufactured by Hitachi Chemical Co., Ltd., thickness: 1.6 mm), and then 40 conductor patterns each having a rectangular shape, 0.3 mm x 8 mm in size, were formed on each of the plates, so as to produce members to be treated. Subsequently, each of the members to be treated was immersed in a microetching agent (MECBRITE CB-801, manufactured by Mec Co., Ltd.) so as to etch the copper foil surface by 1 µm, and then the member was washed with water. Thereafter, the members were immersed into copper surface treating agents of Examples 1 to 26 and Comparative Examples 1 to 4, which each had one of the compositions shown in Table 1 described below, respectively, for 60 seconds. The members were then washed with water, and dried. The temperature of each of the copper surface treating agents was set to 30°C.

Thereafter, a solder paste (TAS650 S10/011/M9.5, manufactured by Solder Coat Co., Ltd.) was printed onto the center of each of the conductor patterns of each of the members. At this time, the printed patterns were each made into a circular form. Moreover, the printed patterns each had a diameter of 0.4 mm and a thickness of 100 µm. After the printing, the same reflow furnace as in the Experiment 1 was used to heat the member to be treated at a temperature for setting the surface temperature of the member into the range of 225 to 230°C for 40 seconds.

About each of the soldered regions (the number thereof: 40) extended by the reflow treatment, the longest diameter was measured with a microscope. The average of the resultant diameters was calculated as the solder extended length.

### (Solderability judgment criterion)

Of the above-mentioned formulations, any formulation wherein the soldering defective percentage was 3% or less in the Experiment 1 and the solder extended length was 2 mm or more in the Experiment 2 was judged as solderability A. Any formulation wherein the soldering defective percentage was more than 3% and 7% or less and the solder extended length was 1 mm or more was judged as solderability B. Any formulation wherein the soldering defective percentage was more than 7% was judged as solderability C. The results are shown in Table 1.

### (Heat resistance)

### (Experiment 3)

Prepared were double-sided copper clad laminates (8 cm x 8 cm) in each of which a copper foil in thickness of 18 µm was caused to adhere onto each surface of a glass epoxy substrate (GEA-67N, manufactured by Hitachi Chemical Co., Ltd., thickness: 1.6 mm). Subsequently, each of the members to be treated was immersed in a microetching agent (MECBRITE CB-801, manufactured by Mec Co., Ltd.) so as to etch the copper foil surface by 1 µm, and then the member was washed with water. Thereafter, the members were immersed into copper surface treating agents of Examples 1 to 26 and Comparative Examples 1 to 4, which each had one of the compositions shown in Table 1 described below, respectively, for 60 seconds. The members were then washed with water, and dried. The temperature of each of the copper surface treating agents was set to 30°C. Next, each of the dried members to be treated was subjected to reflow treatment 2 times. In the reflow treatment, the same reflow furnace as in the Experiment 1 was used to heat the member to be treated at a temperature for setting the surface temperature of the member into the range of 240 to 245°C for 40 seconds per time of the reflow treatment.

### (Heat resistance judgment criterion)

It was checked by the visual observation whether or not each of the samples was discolored as a result of the Experiment 3. Of the samples, any sample wherein discoloration was hardly caused was ranked as A, any sample wherein discoloration was slightly generated was ranked as B, and any sample wherein discoloration was heavily generated was ranked as C. The results are shown in Table 1.

### <Amount of the Coating film>

In the same way as in the Experiment 1, the members to be treated were immersed in the copper surface treating agents of Examples 1 to 26 and Comparative Examples 1 to 4, respectively. The members were each washed with water and dried. The member was then immersed in 25 mL of a mixed solution hydrochloric acid (35% by weight of hydrogen chloride) and methanol (ratio by weight of hydrochloric acid to methanol = 0.5/99.5) for 5 minutes to dissolve the coating film components adhering onto the copper foils into the mixed solution. The mixed solution wherein the coating film components were dissolved was sampled, and then an ultraviolet-visible spectrophotometer (UV-1600, manufactured by Shimadzu Corp.) was used to measure the absorbance of the peak of the first and second benzimidazole compounds, which was near 278 nm. This value was defined as the amount of the coating film. The results are shown in Table 1.

**Table 1**

| | Composition | | | | | Evaluation results | | |
|---|---|---|---|---|---|---|---|---|
| | First benzimidazole compounds | Second benzimidazole compounds | Added azoles | Acids | Other components | Amount of coating film (Abs.) | Solderability | Heat resistance |
| Example 1 | EPrBI(0.08) | NBI(0.12) | - | Acetic acid of 90% by weight conc. (11) | - | 0.75 | A | A |
| Example 2 | EPrBI(0.1) | OBI(0.1) | - | Formic acid of 76% by weight conc. (15) + Caproic acid (0.3) | - | 0.55 | A | A |
| Example 3 | NMBI(0.12) | NBI(0.08) | - | Formic acid of 76% by weight conc. (11) | Zinc (1.0) | 0.58 | A | A |
| Example 4 | NMBI(0.18) | TPBI(0.02) | - | Acetic acid of 90% by weight conc. (20) | - | 0.68 | B | A |
| Example 5 | NMBI(0.2) | BBIB(0.2) | - | Formic acid of 76% by weight conc. (25) | - | 0.52 | A | A |
| Example 6 | NMBI(0.02) | XPBI(0.03) | - | Formic acid of 76% by weight conc. (5) | - | 0.71 | B | B |
| Example 7 | NMBI(0.1) | UBI(0.1) | - | Acetic acid of 90% by weight conc. (11) | - | 0.59 | A | A |
| Example 8 | NMBI(0.1) | COBI(0.1) | - | Acetic acid of 90% by weight conc. (15) + Enanthic acid (0.1) | - | 0.63 | A | A |
| Example 9 | EPeBI(0.08) | XPBI(0.12) | - | Acetic acid of 90% by weight conc. (11) | - | 0.79 | A | A |
| Example 10 | EPeBI(0.1) | UBI(0.1) | - | Formic acid of 76% by weight conc. (11). | - | 0.78 | A | A |
| Example 11 | NMBI(0.04) | NBI(0.16) | - | Formic acid of 76% by weight conc. (11) | - | 0.61 | A | B |
| Example 12 | NMBI(0.1) | UBI(0.1) | 5-Aminotetrazole (0.003) | Acetic acid of 90% by weight conc. (11) | - | 0.63 | A | A |
| Example 13 | NMBI(0.1) | UBI(0.1) | 5-Aminotetrazole (0.01) | Acetic acid of 90% by weight conc. (11) | - | 1.23 | A | A |
| Example 14 | NMBI(0.1) | UBI(0.1) | 5-Aminotetrazole (0.016) | Acetic acid of 90% by weight conc. (11) | - | 1.02 | B | A |
| Example 15 | NMBI(0.1) | UBI(0.1) | 5-Methyltetrazole (0.003) | Acetic acid of 90% by weight conc. (11) | - | 0.66 | A | A |
| Example 16 | NMBI(0.1) | UBI(0.1) | 5-Methyltetrazole (0.01) | Acetic acid of 90% by weight conc. (11) | - | 1.38 | A | A |
| Example 17 | NMBI(0.1) | UBI(0.1) | 5-Methyltetrazole (0.016) | Acetic acid of 90% by weight conc. (11) | - | 1.31 | A | A |
| Example 18 | NMBI(0.1) | UBI(0.1) | 3-Amino-1,2,4-triazole (0.003) | Acetic acid of 90% by weight conc. (11) | - | 0.62 | A | A |
| Example 19 | NMBI(0.1) | UBI(0.1) | 3-Amino-1,2,4-triazole (0.01) | Acetic acid of 90% by weight conc. (11) | - | 1.29 | A | A |
| Example 20 | NMBI(0.1) | UBI(0.1) | 3-Amino-1,2,4-triazole (0.016) | Acetic acid of 90% by weight conc. (11) | - | 1.21 | A | B |
| Example 21 | NMBI(0.1) | UBI(0.1) | 2-Methylimidazole (0.003) | Acetic acid of 90% by weight conc. (11) | - | 0.59 | A | A |
| Example 22 | NMBI(0.1) | UBI(0.1) | 2-Methylimidazole (0.01) | Acetic acid of 90% by weight conc. (11) | - | 0.92 | A | A |
| Example 23 | NMBI(0.1) | UBI(0.1) | 2-Methylimidazole (0.016) | Acetic acid of 90% by weight conc. (11) | - | 0.9 | A | A |
| Example 24 | NMBI(0.1) | UBI(0.1) | 2-Ethylimidazole (0.003) | Acetic acid of 90% by weight conc. (11) | - | 0.71 | A | A |
| Example 25 | NMBI(0.1) | UBI(0.1) | 2-Ethylimidazole (0.01) | Acetic acid of 90% by weight conc. (11) | - | 1.19 | A | A |
| Example 26 | NMBI(0.1) | UBI(0.1) | 2-Ethylimidazole (0.016) | Acetic acid of 90% by weight conc. (11) | - | 1.08 | A | B |
| Comparative example 1 | NMBI(0.2) | - | - | Formic acid of 76% by weight conc. (11) | - | 0.58 | C | A |
| Comparative example 2 | - | XPBI(0.2) | - | Acetic acid of 90% by weight conc. (11) | - | 0.63 | A | C |
| Comparative example 3 | EPrBI(0.1)+NMBI (0.1) | - | - | Acetic acid of 90% by weight conc. (11) | - | 0.58 | C | A |
| Comparative example 4 | - | NBI(0.1) + TPBI(0.1) | - | Acetic acid of 90% by weight conc. (11) | - | 0.61 | A | C |

### Remarks:

In each of Examples 1 to 26 and Comparative Examples 1 to 4, the balance was made of ion exchange water. The numerical value inside parentheses after each of the components represents the percentage-by-weight concentration thereof. In Table 1, the standard nomenclature and the melting point of each of the benzimidazole compounds are as follows:
EPrBI: 2-(1'-ethylpropyl)benzimidazole, melting point= 265°C,
NMBI: 2-(1-naphthylmethyl)benzimidazole, melting point= 241°C,
EPeBI: 2-(1'-ethylpentyl)benzimidazole, melting point= 207°C,
NBI:2-nonylbenzimidazole, melting point = 127°C,
TPBI: 2-(5'-tolyl)penthylenebenzimidazole, melting point = 121°C,
BBIB: 1,4-bisbenzimidazolebutane, melting point = 120°C,
XPBI: 2-(5'-xylyl)pentylenebenzimidazole, melting point = 112°C,
UBI: 2-undecylbenzimidazole, melting point = 109°C, and
COBI: 5-chloro-2-octylbenzimidazole, melting point = 100°C

As is evident from Table 1, it has been ascertained that in the case of using, as benzimidazole compounds, benzimidazole compounds having melting points different from each other by 70°C or more, both of heat resistance and solderability can be satisfied.

### (Experiment 4)

The period of the immersing treatment into each of the copper surface treating agents was changed to 30 seconds. In the same manner as described above except this matter, the solderability, the heat resistance and amount of the coating film thereof were evaluated. The results are shown in Table 2.

**Table 2**

| | Composition | | | | | Evaluation results | | |
|---|---|---|---|---|---|---|---|---|
| | First benzimidazole compounds | Second benzimidazole compounds | Added azoles | Acids | Other components | Amount of the coating film (Abs.) | Solderability | Heat resistance |
| Example 1 | EPrBI(0.08) | NBI(0.12) | - | Acetic acid of 90% by weight conc. (11) | - | 0.38 | B | B |
| Example 2 | EPrBI(0.1) | COBI(0.1) | - | Formic acid of 76% by weight conc. (15) + Caproic acid (0.3) | - | 0.27 | B | B |
| Example 3 | NMBI(0.12) | NBI(0.08) | - | Formic acid of 76% by weight conc. (11) | Zinc (1.0) | 0.22 | B | B |
| Example 4 | NMBI(0.18) | TPBI(0.02) | - | Acetic acid of 90% by weight conc. (20) | - | 0.35 | C | B |
| Example 5 | NMBI(0.2) | BBIB(0.2) | - | Formic acid of 76% by weight conc. (25) | - | 0.22 | B | B |
| Example 6 | NMBI(0.02) | XPBI(0.03) | - | Formic acid of 76% by weight conc. (5) | - | 0.34 | B | B |
| Example 7 | NMBI(0.1) | UBI(0.1) | - | Acetic acid of 90% by weight conc. (11) | - | 0.25 | B | B |
| Example 8 | NMBI(0.1) | COBI(0.1) | - | Acetic acid of 90% by weight conc. (15) + Enanthic acid (0.1) | - | 0.29 | B | B |
| Example 9 | EPeBI(0.08) | XPBI(0.12) | - | Acetic acid of 90% by weight conc. (11) | - | 0.38 | B | B |
| Example 10 | EPeBI(0.1) | UBI(0.1) | - | Formic acid of 76% by weight conc. (11) | - | 0.37 | B | B |
| Example 11 | NMBI(0.09) | NBI(0.16) | - | Formic acid of 76% by weight conc. (11) | - | 0.29 | B | C |
| Example 12 | NMBI(0.1) | UBI(0.1) | 5-Aminotetrazole (0.003) | Acetic acid of 90% by weight conc. (11) | - | 0.35 | B | B |
| Example 13 | NMBI(0.1) | UBI(0.1) | 5-Aminotetrazole (0.01) | Acetic acid of 90% by (11) | - | 0.71 | A | A |
| Example 14 | NMBI(0.1) | UBI(0.1) | 5-Aminotetrazole (0.016) | weight conc. Acetic acid of 90% by weight conc. (11) | - | 0.65 | B | A |
| Example 15 | NMBI(0.1) | UBI(0.1) | 5-Methyltetrazole (0.003) | Acetic acid of 90% by weight conc. (11) | - | 0.38 | B | B |
| Example 16 | NMBI(0.1) | UBI(0.1) | 5-Methyltetrazole (0.01) | Acetic acid of 90% by weight conc. (11) | - | 0.78 | A | A |
| Example 17 | NMBI(0.1) | UBI(0.1) | 5-Methyltetrazole (0.016) | Acetic acid of 90% by weight conc. (11) | - | 0.75 | A | A |
| Example 18 | NMBI(0.1) | UBI(0.1) | 3-Amino-1,2,4-triazole (0.003) | Acetic acid of 90% by weight conc. (11) | - | 0.31 | B | B |
| Example 19 | NMBI(0.1) | UBI(0.1) | 3-Amino-1,2,4-triazole (0.01) | Acetic acid of 90% by weight conc. (11) | - | 0.79 | A | A |
| Example 20 | NMBI(0.1) | UBI(0.1) | 3-Amino-1,2,4-triazole (0.016) | Acetic acid of 90% by weight conc. (11) | - | 0.77 | A | B |
| Example 21 | NMBI(0.1) | UBI(0.1) | 2-Methylimidazole (0.003) | Acetic acid of 90% by weight conc. (11) | - | 0.29 | B | B |
| Example 22 | NMBI(0.1) | UBI(0.1) | 2-Methylimidazole (0.01) | Acetic acid of 90% by weight conc. (11) | - | 0.62 | A | A |
| Example 23 | NMBI(0.1) | UBI(0.1) | 2-Methylimidazole (0.016) | Acetic acid of 90% by weight conc. (11) | - | 0.59 | A | A |
| Example 24 | NMBI(0.1) | UBI(0.1) | 2-Ethylimidazole (0.003) | Acetic acid of 90% by weight conc. (11) | - | 0.33 | B | B |
| Example 25 | NMBI(0.1) | UBI(0.1) | 2-Ethylimidazole (0.01) | Acetic acid of 90% by weight conc. (11) | - | 0.68 | A | A |
| Example 26 | NMBI(0.1) | UBI(0.1) | 2-Ethylimidazole (0.016) | Acetic acid of 90% by weight conc. (11) | - | 0.59 | A | B |
| Comparative example 1 | NMBI(0.2) | - | - | Formic acid of 76% by weight conc. (11) | - | 0.21 | C | C |
| Comparative example 2 | - | XPBI(0.2) | - | Acetic acid of 90% by weight conc. (11) | - | 0.29 | C | C |
| Comparative example 3 | EPrBI(0.1)+NMBI (0.1) | - | - | Acetic acid of 90% by weight conc. (11) | - | 0.25 | C | C |
| Comparative example 4 | - | NBI(0.1) + TPBI(0.1) | - | Acetic acid of 90% by weight conc. (11) | - | 0.27 | C | C |

When amounts of the coating film of Examples 12 to 26, into which an azole other than benzimidazole compounds was added, were compared with those of the other examples, it was understood that the addition of not less than of a predetermined amount of the azole made the speed in forming the coating film higher. As a result, in Examples 13, 14, 16, 17, 19, 20, 22, 23, 25 and 26, better results in at least one of heat resistance and solderability were obtained than the other examples.

According to the copper surface treating agent and the surface treatment method of the invention, both of heat resistance and solderability can be satisfied by the use of two or more benzimidazole compounds having melting points different from each other by 70°C or more as benzimidazole compounds.

## Claims

1. A copper surface treating agent, comprising an acid, benzimidazole compounds and water,
which is **characterized in that** at least a first benzimidazole compound and a second benzimidazole compound having a lower melting point than that of the first benzimidazole compound by 70°C or more are contained as the benzimidazole compounds.

2. The copper surface treating agent according to claim 1, wherein the first benzimidazole compound has a melting point of 200 to 300°C, and
the second benzimidazole compound has a melting point of 95 to 130°C.

3. The copper surface treating agent according to claim 1 or 2, wherein the total concentration of the first and second benzimidazole compounds is from 0.05 to 0.4% by weight.

4. The copper surface treating agent according to any one of claims 1 to 3, wherein the blend ratio by weight of the first benzimidazole compound to the second benzimidazole compound is from 1/9 to 9/1.

5. The copper surface treating agent according to any one of claims 1 to 4, further comprising at least one azole selected from imidazoles other than any benzimidazole compound, triazoles, and tetrazoles.

6. The copper surface treating agent according to claim 5, wherein the value obtained by dividing the concentration of the azole (s) by the total concentration of the first and second benzimidazole compounds is from 0.03 to 0.10.

7. A surface treatment method for treating a copper surface, wherein the copper surface is treated with a copper surface treating agent as recited in any one of claims 1 to 6.
